# EUROPEAN PATENT APPLICATION

(11) **EP 4 600 989 A1**
(43) Date of publication of application: **13.08.2025**
(21) Application number: 24156841.9
(22) Date of filing: 09.02.2024
(51) Int. Cl.: H01J 37/02, H01J 37/24, H01J 5/50

(54) **VACUUM EXPOSURE APPARATUS AND ASSESSMENT SYSTEM**

(71) Applicant: ASML Netherlands B.V., 5500 AH Veldhoven (NL)
(72) Inventor: VAN DER TOORN, Jan-Gerard, Cornelis, 5500 AH Veldhoven (NL); CAO, Mingwei, San Jose, 95134 (US); SLOT, Erwin, 5500 AH Veldhoven (NL)
(74) Representative: ASML Netherlands B.V.

(57) **Abstract**

The present invention provides a vacuum exposure apparatus. The vacuum exposure apparatus comprises: a vacuum chamber; a stage disposed within the vacuum chamber and configured to support a sample; a high voltage power supply unit disposed within the vacuum chamber; a high voltage power source disposed exterior to the vacuum chamber; and exactly one high voltage cable extending between the high voltage power supply unit to an exterior of the vacuum chamber. A first end of the high voltage cable is connected to the high voltage power supply unit. A second end of the high voltage cable is connected to the high voltage power source. The high voltage cable is configured to carry a higher voltage than is output by the high voltage power source.

## Description

### FIELD

The embodiments provided herein generally relate to a vacuum exposure apparatus and an assessment system comprising the vacuum exposure apparatus.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment, e.g., inspection and/or measurement, of a surface of a substrate, or other object/material, is an important process during and/or after its manufacture.

Pattern assessment systems, otherwise referred to as inspection systems, with a charged particle beam have been used to inspect objects, for example to detect pattern defects and to measure structural features on such objects. These tools typically use electron microscopy techniques, using electron optical systems for example in a scanning electron microscope (SEM). In exemplary electron optical system such a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over, or across, the sample surface, secondary electrons can be emitted across the surface of the sample. By collecting these emitted secondary electrons from the sample surface, a pattern assessment system (or assessment tool) may obtain an image representing characteristics of the material structure of the surface of the sample. The intensity of the electron beams comprising the backscattered electrons and the secondary electrons may vary based on the properties of the internal and external structures of the sample, and thereby may indicate whether the sample has defects.

The assessment system, typically comprises a stage, such as an actuated stage, configured to support a sample to be inspected. The stage comprises a number of high voltage electrodes, in addition to plates and electron-lens elements at a similar high voltage potential. Those different electrodes are connected to the same high voltage supply unit. This single high voltage supply unit is disposed outside the vacuum chamber which houses the stage and components of the electron optical system (e.g., a SEM). Typically, there is not a significant difference between the voltages of these different electrodes. In other words, the system is not configured to account for high mutual voltage difference. In particular, the electrodes are often disposed in close proximity to each other with no shielding provided between adjacent electrodes. This is because it may be considered unnecessary to provide such protective measures when the different electrodes have the same or similar voltages. Furthermore, the available volume may not allow protective measures to be readily included.

Nonetheless, an unintended discharge (which may be referred to as a primary discharge) can occur between one of the high voltage electrodes and another component of the system that is at a different potential, most likely at ground potential. In these circumstances, the voltage of this electrode drops significantly. Due to the inherent impedance of the components of the system, in particular connecting cables, not all components that are connected to each other keep the same voltage. The voltage differences may exceed a voltage level that can result in consequential arcing between the components. This type of arcing, or discharge, may be known as a secondary discharge.

The placement of the high voltage supply unit outside the vacuum chamber necessitates the use of high voltage cables of sufficient length to connect the high voltage supply unit outside the vacuum chamber to the stage within the vacuum chamber, and to allow the stage to move within the vacuum chamber. The long cumulative length of high voltage cables can result in a large capacitance and hence energy storage that is released during discharged.

These primary and secondary discharges can cause damage to the system, and may contaminate the system by generation of particles. As such, it is desirable to reduce the risk of such discharges to reduce the likelihood of disruption to the sample inspection process.

### SUMMARY

It is an object of the present disclosure to provide embodiments of a vacuum exposure apparatus and an assessment system comprising the vacuum exposure apparatus.

According to a first aspect of the invention, there is provided a vacuum exposure apparatus. The vacuum exposure apparatus comprises: a vacuum chamber; a stage disposed within the vacuum chamber and configured to support a sample; a high voltage power supply unit disposed within the vacuum chamber; a high voltage power source disposed exterior to the vacuum chamber; and a high voltage cable extending between the high voltage power supply unit to an exterior of the vacuum chamber. A first end of the high voltage cable is connected to the high voltage power supply unit. A second end of the high voltage cable is connected to the high voltage power source. The high voltage cable is configured to carry a higher voltage than is output by the high voltage power source.

According to a second aspect of the invention, there is provided an assessment system, comprising the vacuum exposure apparatus.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary electron beam assessment apparatus.
**FIG. 2** is a schematic diagram illustrating an exemplary multi-beam charged particle assessment system that is part of the exemplary electron beam assessment apparatus of **FIG. 1****.**
**FIG. 3** is a schematic diagram illustrating an exemplary assessment system of the prior art.
**FIG. 4** is a schematic diagram illustrating an assessment system according to an embodiment.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus semiconductor IC manufacturing is a complex and time-consuming process, with many individual steps. An error in one of these steps has the potential to significantly influence the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by assessment systems (such as, or such as comprising, a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. Such an assessment apparatus may utilize a single primary electron beam incident on a sample. For high throughput inspection, some of the assessment apparatuses use multiple focused beams, i.e. a multi-beam, of primary electrons. The component beams of the multi-beam may be referred to as sub-beams or beamlets. The sub-beams may be arranged with respect to each other within the multi-beam in a multi-beam arrangement. A multi-beam can scan different parts of a sample simultaneously. A multi-beam assessment apparatus can therefore assess, for example inspect, a sample at a much higher speed than a single-beam assessment apparatus.

An implementation of known multi-beam assessment apparatus and systems is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

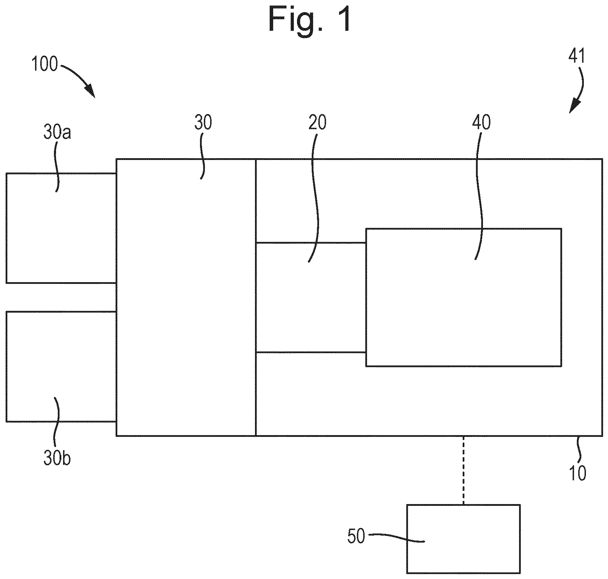

Reference is now made to **FIG. 1****,** which is a schematic diagram illustrating an exemplary charged particle beam assessment apparatus 100. It should be noted that the assessment apparatus comprises part of the assessment system, often the part of the assessment system situated in a fabrication facility. The assessment apparatus may cover a surface area of the fabrication facility floor referred to as an apparatus footprint. The other parts of the assessment system such as service systems of vacuum and fluid supplies and remote processing racks may be located elsewhere in the fabrication facility away from other fabrication systems and apparatus where space is a less significant requirement,

The charged particle beam assessment apparatus 100 of **FIG. 1** includes a main chamber 10, a load lock chamber 20, a charged particle assessment system 40 (which may also be called an electron beam system or tool), an equipment front end module (EFEM) 30 and a controller 50. The charged particle assessment system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be assessed e.g. measured or inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the charged particle assessment system 40 by which it may be assessed. The charged particle assessment system 40 comprises a charged particle device 41. The charged particle device 41 may be an electron-optical device, which may be synonymous with the electron-optical system. The charged particle device 41 may be a multi-beam charged particle device 41 configured to project a multi-beam towards the sample, for example the sub-beams being arranged with respect to each other in a multi-beam arrangement. Alternatively, the charged particle device 41 may be a single beam charged particle device 41 configured to project a single beam towards the sample.

The controller 50 is electronically connected to the charged particle assessment system 40. The controller 50 may be a processor (such as a computer) configured to control the charged particle beam assessment apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it can be distributed over at least two of the component elements. While the present disclosure provides examples of the main chamber 10 housing an electron beam assessment apparatus, it should be noted that aspects of the disclosure in their broadest sense are not limited to a chamber housing an electron beam assessment apparatus. Rather, it is appreciated that the foregoing principles may also be applied to other tools and other arrangements of apparatus, that operate under the second pressure.

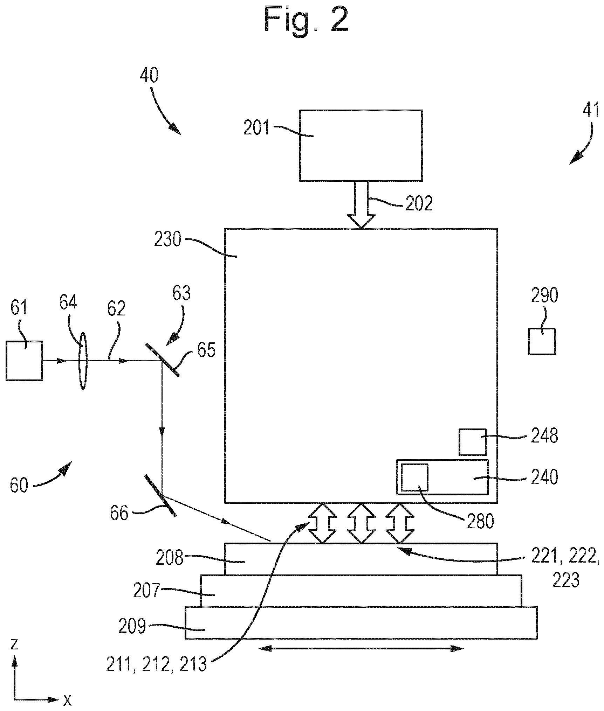

Reference is now made to **FIG. 2****,** which is a schematic diagram illustrating an exemplary charged particle assessment system 40 including a multi-beam charged particle device 41 that is part of the exemplary charged particle beam assessment apparatus 100 of **FIG. 1****.** The multi-beam charged particle device 41 comprises an electron source 201 and a projection apparatus 230. The charged particle assessment system 40 further comprises an actuated stage 209 and a sample holder 207. The sample holder may have a holding surface (not depicted) for supporting and holding the sample. Thus the sample holder may be configured to support the sample. Such a holding surface may be a electrostatic clamp operable to hold the sample during operation of the charged particle device 41 e.g. assessment such as measurement or inspection of at least part of the sample. The holding surface may be recessed into sample holder, for example a surface of the sample holder orientated to face the charged particle device 41. The electron source 201 and projection apparatus 230 may together be referred to as the charged particle device 41. The sample holder 207 is supported by actuated stage 209 so as to hold a sample 208 (e.g., a substrate or a mask) for assessment. The multi-beam charged particle device 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam assessment apparatus 100 of **FIG. 1****,** such as the electron source 201, the detector 240, the projection apparatus 230, and the actuated stage 209. The controller 50 may perform various image and signal processing functions. The controller 50 may also generate various control signals to govern operations of the charged particle beam assessment apparatus, including the charged particle multi-beam apparatus.

The projection apparatus 230 may be configured to focus sub-beams 211, 212, and 213 onto a sample 208 for assessment and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy < 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam charged particle assessment system 40 such as the detector 240 (as shown in **FIG. 2**). However, the signal processing system 280 may be incorporated into any components of the assessment apparatus 100 or multi-beam charged particle assessment system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under assessment. The reconstructed images can be used to reveal various features of the internal or external structures of the sample 208. The reconstructed images can thereby be used to reveal any defects that may exist in the sample.

The controller 50 may control the actuated stage 209 to move sample 208 during assessment, e.g. inspection, of the sample 208. The controller 50 may enable the actuated stage 209 to move the sample 208 in a direction, preferably continuously, for example at a constant speed, at least during sample assessment. The controller 50 may control movement of the actuated stage 209 so that it changes the speed of the movement of the sample 208 dependent on various parameters. For example, the controller 50 may control the stage speed (including its direction) depending on the characteristics of the assessment steps of scanning process.

Known multi-beam systems, such as the charged particle assessment system 40 and charged particle beam assessment apparatus 100 described above, are disclosed in US2020118784, US20200203116, US 2019/0259570 and US2019/0259564 which are hereby incorporated by reference.

As shown in **FIG. 2****,** in an embodiment the charged particle assessment system 40 has a single charged particle device 41 and optionally comprises a projection assembly 60. The projection assembly 60 may be a module and may be referred to as an ACC module. The projection assembly 60 is arranged to direct a light beam 62 such that the light beam 62 enters between the charged particle device 41 and the sample 208.

When the electron beam scans the sample 208, charges may be accumulated on the sample 208 due to large beam current, which may affect the quality of the image. To regulate the accumulated charges on the sample, the projection assembly 60 may be employed to illuminate the light beam 62 on the sample 208, so as to control the accumulated charges due to effects such as photoconductivity, photoelectric, or thermal effects.

The assessment system, or inspection system, typically comprises a stage, such as an actuated stage, configured to support a sample to be inspected. The stage comprises a number of high voltage electrodes, in addition to plates and electron-lens elements at a similar high voltage potential. Those different electrodes are connected to the same high voltage supply unit. This single high voltage supply unit is a high voltage power supply disposed outside the vacuum chamber which houses the stage and components of the electron optical system. The high voltage supply unit may be configured to supply different bias voltages to the different electrodes. Typically, there is not a significant difference between the voltages of these different electrodes. In other words, the system is not configured to account for high mutual voltage difference. In particular, the electrodes are often disposed in close proximity to each other with no shielding provided between adjacent electrodes. This is because it may be considered unnecessary to provide such protective measures when the different electrodes have the same or similar voltages.

Nonetheless, an unintended discharge (which may be referred to as a primary discharge) can occur between one of the high voltage electrodes and another component of the system that is at a different potential, most likely at ground potential. In these circumstances, the voltage of this electrode drops significantly. Due to the inherent impedance of the components of the system, in particular connecting cables, not all components that are connected to each other keep the same voltage. The voltage differences may exceed a voltage level that can result in consequential arcing between the components. This type of arcing, or discharge, may be known as a secondary discharge. These primary and secondary discharges can cause damage to the system, and may contaminate the system by generation of particles. As such, it is desirable to reduce the risk of such discharges to reduce the likelihood of disruption to the sample inspection process.

Although this disclosure is directed mainly to reducing a risk of discharges in an assessment system, the same issues related to primary and/or secondary discharges may occur in vacuum exposure apparatus for other applications or purposes. In other words, it may be desirable to avoid the above described problems in vacuum exposure apparatus, comprising a sample stage, used for different purposes other than sample inspection.

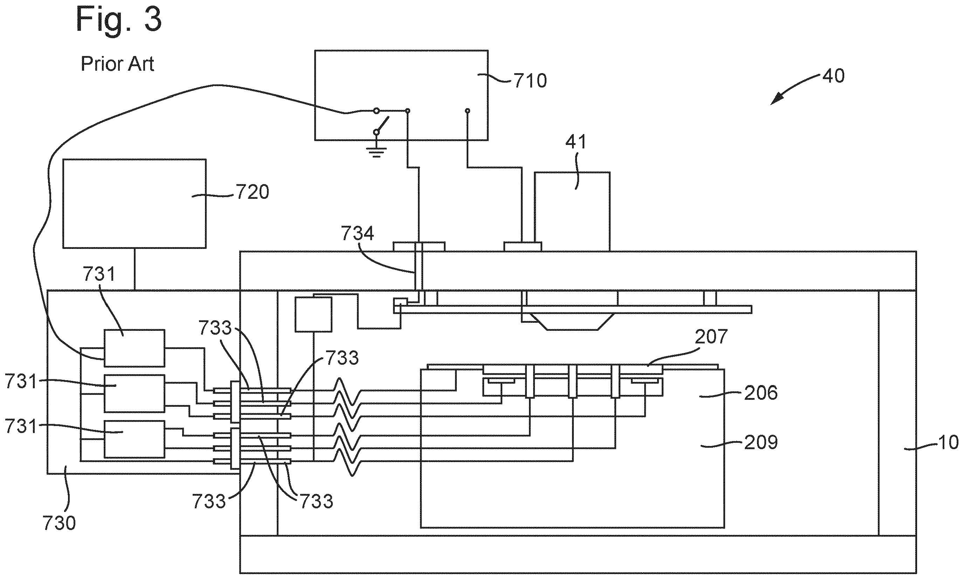

**FIG. 3** is a schematic diagram illustrating an exemplary assessment system of the prior art, such as described above in relation to problems of discharge in existing assessment systems. The assessment system of **FIG.3** comprises a vacuum chamber 10, a stage 209, a high voltage power supply unit 730, and a high voltage power source 710.

The vacuum chamber 10 is configured to support a vacuum environment within the vacuum chamber 10. The vacuum chamber 10 comprises walls defining the vacuum chamber and separating the vacuum environment within the vacuum chamber from an atmospheric environment outside the vacuum chamber 10. The stage 209 is configured to support a sample. The stage may comprise a sample holder 207. The stage 209 may be an actuated stage, such as that described above with reference to **FIG. 2****.** The stage 209 is disposed within the vacuum chamber 10. The stage 209 is configured to operate within the vacuum environment.

In the arrangement of **FIG. 3****,** the high voltage power supply unit 730 is disposed outside the vacuum chamber 10. A high voltage power source 710 is disposed outside the vacuum chamber 10. The high voltage power source 710 is connected to the high voltage power supply 730. A plurality of high voltage cables 733 extend between the high voltage power supply unit 730 and an interior of the vacuum chamber 10. The high voltage cables 733 may provide power to components of the stage 209.

The assessment system 40 of **FIG. 3** comprises a charged particle device 41 such as that described above with reference to **FIG. 2****.** In particular, the charged particle device 41 comprises charged particle-optical elements configured to project a beam of charged particles towards the sample. The charged particle-optical elements are disposed within a vacuum environment. The charged particle-optical elements may be disposed within the vacuum chamber 10.

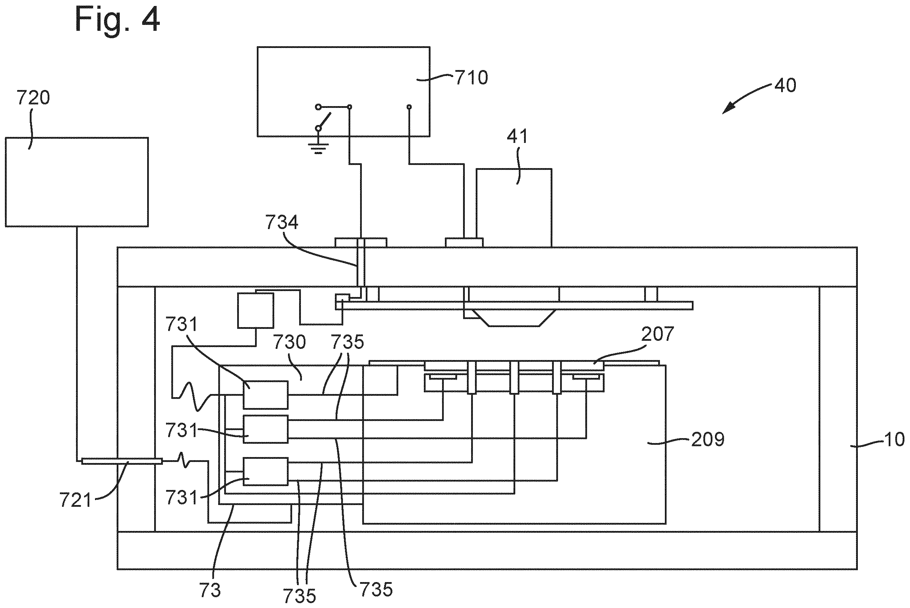

**FIG. 4** is a schematic diagram illustrating an assessment system according to an embodiment. Similarly to the arrangement of **FIG. 3****,** the assessment system of **FIG. 4** comprises a vacuum chamber 10, a stage 209, a high voltage power supply unit 730, and a high voltage power source 710.

The vacuum chamber 10 is configured to support a vacuum environment within the vacuum chamber 10. The vacuum chamber 10 comprises walls defining the vacuum chamber and separating the vacuum environment within the vacuum chamber from an atmospheric environment outside the vacuum chamber 10. The stage 209 is configured to support a sample. The stage may comprise a sample holder 207. The stage 209 may be an actuated stage, such as that described above with reference to **FIG. 2** and **FIG. 3**. The stage 209 is disposed within the vacuum chamber 10. The stage 209 is configured to operate within the vacuum environment.

The high voltage power supply unit 730 is disposed within the vacuum chamber 10. In other words, the high voltage power supply unit 730 is inside the vacuum chamber 10 and is configured to operate within a vacuum environment. The high voltage power source 710 is disposed exterior to the vacuum chamber 10. In other words, the high voltage power supply 710 is outside the vacuum chamber 10 and is configured to operate in an atmospheric environment.

In the arrangement of **FIG. 4****,** a high voltage cable 734 extends between the high voltage power supply unit 730 to an exterior of the vacuum chamber 10. A first end of the high voltage cable 734 is connected to the high voltage power supply unit 730. A second end of the high voltage cable 734 is connected to the high voltage power source 710. In the arrangement of **FIG. 4****,** exactly one high voltage cable 734 extends between the high voltage power supply unit 730 and an exterior of the vacuum chamber 10. In other words, a single high voltage cable 734 connects the high voltage power supply 710 outside the vacuum chamber 10 to the high voltage power supply unit 730 inside the vacuum chamber 10. The high voltage cable 734 is configured to carry a higher voltage than is output by the high voltage power source 710. In alternative arrangements, there may be more than one high voltage cable 734 extending between the high voltage power supply unit 730 and an exterior of the vacuum chamber 10. However, it is desirable for the number of high voltage cables extending between the high voltage power supply unit 730 and an exterior of the vacuum chamber 10 to be low. For example, there may be up to 6 high voltage cables extending between the high voltage power supply unit 730 and an exterior of the vacuum chamber 10, more desirably up to 4 high voltage cables, yet more desirably up to 2 high voltage cables. In the preferred arrangement, as shown in **FIG. 4****,** there is exactly one high voltage cable extending between the high voltage power supply unit 730 and an exterior of the vacuum chamber 10.

With the arrangement of **FIG. 4****,** only one single high voltage cable 734 is used to provide power from the high voltage power supply 710 to components within the interior of the vacuum chamber 10, via the high voltage power supply unit 730. This is in contrast to the comparative exemplary arrangement of **FIG. 3** in which a plurality of high voltage cables 733 are used to provide power from the high voltage power supply 710 to components within the interior of the vacuum chamber 10, via the high voltage power supply unit 730.

The high voltage power supply unit 730 may be configured to provide mutual bias voltages to components of the stage 209. The vacuum exposure apparatus may comprise electrostatic clamp configured to clamp the sample to the stage 209. The high voltage power supply unit 730 is desirably configured to power the electrostatic clamp. The mutual bias voltage provided by the high voltage power supply unit 730 may also be used to compensate for deviating edge effects on a sample on the stage 209. Furthermore, the mutual bias voltage provided by the high voltage power supply unit 730 may be used to ensure proper grounding of the sample. Additionally, the mutual bias voltage provided by the high voltage power supply unit 730 may be used for diagnostic purposes.

In the arrangement of **FIG. 4****,** the high voltage power supply unit 730 that provides the high voltage and mutual bias voltages to the different components of the stage 209 is disposed within the vacuum chamber 10. In this way, the high voltage power supply 730 may be in close proximity to, or even in contact with, the stage 209. As a consequence, the length of cables extending between the high voltage power supply unit 730 and the corresponding components of the stage 209 to be powered thereby, the length of the cables may be greatly reduced, particularly in comparison to an arrangement such as that of FIG. 3 where the high voltage power supply unit 730 is outside the vacuum chamber 10. This reduction in length of the cables may also reduce the impedance of the connection between the high voltage components. This reduction in impedance may have the desirably effect that relative voltage difference resulting in (primary or secondary) discharge may be largely reduced. This may significantly reduce particle generation, damage to the system, damage to samples, and associated disruption of the sample inspection process. In other words, with an arrangement such as that of **FIG. 4****,** the voltage difference resulting from primary discharge is lowered such that the likelihood of secondary discharge occurring (as a consequence of primary discharge) is significantly reduced. This reduction in, or elimination of, secondary discharge may result in a reduction in the amount of particle contamination that may otherwise be caused by discharge/arcing.

In the exemplary arrangement of **FIG. 3****,** a plurality of high voltage cables 733 extend from outside to inside the vacuum chamber 10 in order to provide high voltage power to components of the stage 209. In particular, in the arrangement of **FIG. 3****,** six high voltage cables are used to provide a connection between the high voltage power source 710 outside of the vacuum chamber 10 and the stage 209 inside the vacuum chamber 10. In the embodiment of **FIG. 4****,** the system is configured such that only one high voltage cable 734 extends from outside to inside the vacuum chamber 10 in order to provide high voltage power to components of the stage 209. This means a significant reduction in the dominant cable capacitance in the embodiment of **FIG. 4** compared to the comparative example arrangement of **FIG. 3****.** Furthermore, the path-length of high voltage cable in the system may be reduced in the arrangement of **FIG. 4** compared to that of **FIG. 3****.** The reduction in number and length of high voltage cables may have several associated advantages. For example, the stage 209 is not connected to as large a mass of cable during use, which may make the actuation of the stage more energy efficient and more accurate. Furthermore, there may be a reduction in cost of the cable and cost of purchase/manufacture and installation of associated feedthroughs for the cables, particularly feedthroughs between an atmospheric environment and a vacuum environment. A reduction in number and/or length of cable may also have the advantage of reducing an amount of contamination that may otherwise be caused by outgassing of the sleeve material around the cables. A reduction in length and number of cables may also be associated with a reduction in the risk of failure of a cable, which may otherwise require maintenance and repair work resulting in system downtime. Furthermore, a reduction in length and/or number of cables may also result in a reduction in the amount of energy stored in the system at a given time. Furthermore, the reduction in number of cables may provide a more direct means for troubleshooting and diagnostics. This may makes the system more robust.

As shown, for example, in **FIG. 4****,** the high voltage power supply unit 730 may be attached to the stage 209. The high voltage power supply unit 730 is desirably kept relatively light-weight and has a small volume, in order to enable the high voltage power supply unit 730 to fit in the vacuum chamber 10 and desirably to be positioned on or around the stage 209. In order to achieve this reduction in weight and/or volume, certain components may be disposed separate from the high voltage power supply unit 730 and outside of the vacuum chamber 10. For example, as shown in **FIG. 4****,** the high voltage power supply 710 is disposed outside of the vacuum chamber 10.

Furthermore, the vacuum exposure apparatus may further comprise a plurality of control electronics components configured to control the high voltage power supply unit 730. In some arrangements, all of the control electronics components may be disposed within the vacuum environment. Desirably, at least some of the control electronics are disposed outside the high voltage power supply unit 730. More desirably, all of the control electronics components are disposed outside the high voltage power supply unit 730. Yet more, desirably, at least some of the control electronics components are disposed outside the vacuum chamber 10. In this way, space and weight of the high voltage power supply unit 730 may be reduced compared to an arrangement wherein all of the control electronics components are disposed within the high voltage power supply unit 730.

The stage 209 is desirably an actuated stage, and the high voltage power supply unit 730 is desirably attached to an actuated part of the stage 209. In other words, at least part of the stage 209 may be configured to move and the high voltage power supply unit 730 may be configured to move together with the at least part of the stage 209 as it moves. The high voltage power supply unit 730 is desirably rigidly attached to the stage 209, and in particular is desirably rigidly attached to an actuatable part of the stage 209. For example, the high voltage power supply unit 730, may be rigidly clamped, glued or bolted to the stage 209. In this way, the high voltage power supply unit 730 is able to move together with the actuated stage 209. This means that there is not undue stress caused in cables 735 due to relative motion between the stage 209 and the high voltage power supply unit 730. Furthermore, the influence of dynamic interaction between the stage 209 and the high voltage power supply unit 730 is reduced by using a rigid, as opposed to flexible, connection between the stage 209 and the high voltage power supply unit 730. As such, accuracy of movement of the actuated stage 209 may be maintained even with the high voltage power supply unit 730 mounted on an actuated part of the stage 209.

The stage 209 may comprises a first actuated part configured to support the sample. The first actuated part may comprise or consist of the sample holder 207. The stage 209 may comprise a second actuated part 206 configured to support the first actuated part 207. In other words, the stage 209 may comprise a first actuated part 207 on which the sample may be mounted and the stage 209 may further comprise a second actuated part 206 on which the first actuated part 207 is mounted.

The high voltage power supply unit 730 is desirably attached to the second actuated part 206. In this way, the presence of the high voltage power supply unit 730 on the stage 209 should not significantly influence the accuracy and performance of the more precise first actuated part 207 of the stage 209.

The second actuated part 206 desirably has a larger range of motion than the first actuated part 207. In other words, the second actuated part 206 may be configured for more gross movement compared to the first actuated part 207. The first actuated part 207 may be configured for more fine movement than the second actuated part 206. The first actuated part 207 may be configured for more precise movement than the second actuated part 206. The first actuated part 207 may be configured to move in more degrees of freedom than the second actuated part 206. For example, the second actuated part 206 may be configure to move in two or three degrees of freedom, such as translational degrees of freedom. The first actuated part 207 may be configured to move in one or more rotational degrees of freedom as well as one or more translational degrees of freedom.

The second actuated part 206 of the stage 209 may comprise a cooling system. The high voltage power supply unit 730 is desirably in thermal contact with the second actuated part 206 of the stage 209. The thermal contact may be provided by any available means, which is suitable for use in a vacuum environment. For example, thermal contact may be provided by a mechanical interface between the second actuated stage 206 and the high voltage power supply unit 730, such as interfacing surfaces in contact across a substantial area of the interface between the second actuated stage 206 and the high voltage power supply unit 730. Additionally, or alternatively, a soft sheet (for example, a sheet of tin, copper, indium, or thermal conductive foam) may be disposed at the interface between the second actuated stage 206 and the high voltage power supply unit 730. Alternatively, or additionally, a heat-pipe, may be provided to promote thermal contact between the second actuated stage 206 and the high voltage power supply unit 730. In this way, the cooling system of the stage 209 may also be used to cool the high voltage power supply unit 730.

In the arrangement of **FIG. 4****,** the high voltage power supply unit 730 comprises a housing 73 configured to house high voltage components 731 of the high voltage power supply unit 730. The high voltage power supply unit 730 further comprises a potting material disposed within the housing 73. The potting material desirably substantially fills a space between the housing 73 and the high voltage components 731 of the high voltage power supply unit 730 disposed within the housing 73. In other words, it is desirable that a majority of space between interior walls of the housing 73 and high voltage components 731 disposed within the housing 73 is filled with potting material. The use of potting material may desirably reduce the risk of discharges between components at different voltages.

The housing 73 is desirably tightly fitted around the components disposed within the housing 73. In other words, the housing 73 is desirably configured to reduce the amount of free space within the housing 73, not taken up by components of the high voltage power supply unit 730. In this way, the space between the components and the interior walls of the housing 73 may be filled with potting material without the need to use a substantial amount of potting material. In other words, the housing 73 may make an efficient use of space to reduce the volume of potting material to be used, therefore saving space and cost. Furthermore, the number and size of openings in the housing 73 are also desirably low. In particular, openings may be provided only to allow cables to connect to/from the high voltage power supply unit 730. In this way, an amount of exposed potting material surface is kept low. This may desirably reduce contamination due to outgassing of the potting material.

The high voltage power supply unit 730 further may further comprise a plurality of terminals. The different terminals of the high voltage power supply unit 730 may be configured to operate on different voltages. Potting material desirably substantially fills a space between different high voltage components 731 and terminals. For example, potting material may be disposed between adjacent terminals configured to operate at different voltages to each other. Furthermore, potting material may be disposed between adjacent high voltage components 731 of the high voltage power supply unit 730. Additionally, or alternatively, potting material may be disposed between a terminal and an adjacent high voltage component 731 of the high voltage power supply unit 730. In this way, a likelihood of discharges between components and/or terminals of the high voltage power supply unit 730 may desirably be reduced by the use of potting material.

As shown in FIG. 4, the high voltage power supply unit 730 may optionally be connected to a low voltage power source 720. In the arrangement of FIG. 4, the low voltage power source 720 is disposed exterior to the vacuum chamber 10. A low voltage cable 721 extends between the high voltage power supply unit 730 and an exterior of the vacuum chamber 10. A first end of the low voltage cable 721 is connected to the high voltage power supply unit 730. A second end of the low voltage cable 721is connected to the low voltage power source 720. The low voltage cable 721 may be configured to carry a higher voltage than is output by the low voltage power source 710. The low voltage cable 721 is configured to carry a lower voltage the high voltage cable 734 is configured to carry.

An assessment system, or inspection system, according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical device 41 may be a component of a charged particle assessment system 40; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "beam" may be used synonymously with "sub-beam" and "beamlet". The term "manipulator" is used to encompass any element which affects the path of a sub-beam or beamlet, such as a lens or deflector.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

Embodiments include the following numbered clauses:
1. A vacuum exposure apparatus comprising:
   a vacuum chamber;
   a stage configured to support a sample, wherein the stage is disposed within the vacuum chamber;
   a high voltage power supply unit disposed within the vacuum chamber;
   a high voltage power source disposed exterior to the vacuum chamber; and
   a high voltage cable extending between the high voltage power supply unit to an exterior of the vacuum chamber,
   wherein a first end of the high voltage cable is connected to the high voltage power supply unit and a second end of the high voltage cable is connected to the high voltage power source, and
   wherein the high voltage cable is configured to carry a higher voltage than is output by the high voltage power source.
2. The apparatus of clause 1, wherein there is exactly one high voltage cable extending between the high voltage power supply unit to an exterior of the vacuum chamber.
3. The apparatus of either of clauses 1 and 2, wherein the high voltage power supply unit is attached to the stage.
4. The apparatus of clause 3, wherein
   the stage is an actuated stage, and
   the high voltage power supply unit is attached to an actuated part of the stage.
5. The apparatus of clause 4, wherein the stage comprises a first actuated part configured to support the sample and a second actuated part configured to support the first actuated part, wherein the high voltage power supply unit is attached to the second actuated part.
6. The apparatus of clause 5, wherein the second actuated part has a larger range of motion than the first actuated part.
7. The apparatus of either of clauses 5 and 6, wherein the second actuated part of the stage comprises a cooling system.
8. The apparatus of clause 7, wherein the power supply unit is in thermal contact with the second actuated part of the stage.
9. The apparatus of any clauses 3 to 8, wherein the high voltage power supply unit is rigidly attached to the stage.
10. The apparatus of any of the preceding clauses, wherein the high voltage power supply unit is configured to provide mutual bias voltages to components of the stage.
11. The apparatus of clause 10, further comprising an electrostatic clamp configured to clamp the sample to the stage, wherein the high voltage power supply unit is configured to power the electrostatic clamp.
12. The apparatus of any of the preceding clauses, wherein the high voltage power supply unit comprises a housing configured to house high voltage components of the high voltage power supply unit.
13. The apparatus of clause 12, wherein the high voltage power supply unit further comprises a potting material is disposed within the housing.
14. The apparatus of clause 13, wherein the potting material substantially fills a space between the housing and the high voltage components of the high voltage power supply unit disposed within the housing.
15. The apparatus of any of the preceding clauses, wherein the high voltage power supply unit further comprises a plurality of terminals, wherein different terminals are configured to operate on different voltages,
   wherein the potting material substantially fills a space between different high voltage components and terminals.
16. The apparatus of any of the preceding clauses, further comprising a plurality of control electronics components configured to control the high voltage power supply unit, wherein at least some of the control electronics components are disposed within the vacuum chamber.
17. An assessment system, comprising the apparatus of any of the preceding clauses, wherein the assessment system is configured to inspect a sample supported on the stage.
18. The assessment system of clause 17, further comprising a charged particle device comprising charged particle-optical elements configured to project a beam of charged particles towards the sample.
19. The assessment system of clause 18, wherein the charged particle-optical elements are disposed within the vacuum chamber.

## Claims

1. A vacuum exposure apparatus comprising:
a vacuum chamber;
a stage configured to support a sample, wherein the stage is disposed within the vacuum chamber;
a high voltage power supply unit disposed within the vacuum chamber;
a high voltage power source disposed exterior to the vacuum chamber; and
a high voltage cable extending between the high voltage power supply unit to an exterior of the vacuum chamber,
wherein a first end of the high voltage cable is connected to the high voltage power supply unit and a second end of the high voltage cable is connected to the high voltage power source, and
wherein the high voltage cable is configured to carry a higher voltage than is output by the high voltage power source.

2. The apparatus of claim 1, wherein there is exactly one high voltage cable extending between the high voltage power supply unit to an exterior of the vacuum chamber.

3. The apparatus of either of claims 1 and 2, wherein the high voltage power supply unit is attached to the stage.

4. The apparatus of claim 3, wherein
the stage is an actuated stage, and
the high voltage power supply unit is attached to an actuated part of the stage.

5. The apparatus of claim 4, wherein the stage comprises a first actuated part configured to support the sample and a second actuated part configured to support the first actuated part, wherein the high voltage power supply unit is attached to the second actuated part.

6. The apparatus of claim 5, wherein the second actuated part has a larger range of motion than the first actuated part.

7. The apparatus of any of the preceding claims, wherein the high voltage power supply unit is configured to provide mutual bias voltages to components of the stage.

8. The apparatus of claim 7, further comprising an electrostatic clamp configured to clamp the sample to the stage, wherein the high voltage power supply unit is configured to power the electrostatic clamp.

9. The apparatus of any of the preceding claims, wherein the high voltage power supply unit comprises a housing configured to house high voltage components of the high voltage power supply unit.

10. The apparatus of claim 9, wherein the high voltage power supply unit further comprises a potting material is disposed within the housing.

11. The apparatus of claim 10, wherein the potting material substantially fills a space between the housing and the high voltage components of the high voltage power supply unit disposed within the housing.

12. The apparatus of any of the preceding claims, wherein the high voltage power supply unit further comprises a plurality of terminals, wherein different terminals are configured to operate on different voltages,
wherein the potting material substantially fills a space between different high voltage components and terminals.

13. An assessment system, comprising the apparatus of any of the preceding claims, wherein the assessment system is configured to inspect a sample supported on the stage.

14. The assessment system of claim 13, further comprising a charged particle device comprising charged particle-optical elements configured to project a beam of charged particles towards the sample.

15. The assessment system of claim 14, wherein the charged particle-optical elements are disposed within the vacuum chamber.
